**Europäisches Patentamt**

**European Patent Office**

**Office européen des brevets**

(11) Veröffentlichungsnummer: **0 450 159 A2**

# (12) EUROPÄISCHE PATENTANMELDUNG

(21) Anmeldenummer: 90123237.1

(51) Int. Cl.5: **G11C 11/409**

(22) Anmeldetag: 04.12.90

(30) Priorität: 28.03.90 DE 4009953

(43) Veröffentlichungstag der Anmeldung:
09.10.91 Patentblatt 91/41

(84) Benannte Vertragsstaaten:
**AT DE FR GB IT NL**

(71) Anmelder: **SIEMENS AKTIENGESELLSCHAFT**
**Wittelsbacherplatz 2**
**W-8000 München 2(DE)**

(72) Erfinder: **Lustig, Bernhard, Dr. rer. nat.**
**Helmut-Käutner-Strasse 15**
**W-8000 München 83(DE)**

(54) DRAM-Zellenfeldarchitektur mit übergeordneten Bitschalterleitungen und übergeordneten Bitleitungen.

(57) Die Erfindung betrifft eine DRAM-Zellenfeldarchitektur, bei der in jedem einzelnen Speicherblock durch Bitschalter (5 bis 12) jeweils aus einer Mehrzahl von Bitleitungspaaren ein Bitleitungspaar ($BL_j$, $BL_{j+2}$) ausgewählt wird und aus den in jedem Speicherblock jeweils ausgewählten Bitleitungspaaren wiederum nur die Bitleitungspaare des ausgewählten Speicherblocks auf die übergeordneten Bitleitungen ($IO_k$ bis $IO_{k+3}$) durchgeschaltet werden. Die übergeordneten Bitleitungen können dabei gemeinsam mit den die Bitschalter ansteuernden, übergeordneten Bitschalterleitungen ($CSL_k$ bis $CSL_{k+3}$) in einer einzige, beispielsweise der zweiten Metallisierungsebene verlaufen, wodurch diese besser genutzt ist. Durch die Erfindung können je nach erforderlichem Parallelisierungsgrad Bewerter auf Grund der übergeordneten Bitleitungen eingespart werden, wobei beim Einzelzugriff der Vorteil einer kurzen Zugriffszeit bei mäßiger Leistungsaufnahme erhalten bleibt.

EP 0 450 159 A2

Die Erfindung betrifft eine DRAM-Zellenfeldarchitektur mit übergeordneten Bitschalterleitungen nach dem Oberbegriff des Patentanspruchs 1.

Eine DRAM-Zellenfeldarchitektur dieser Art ist aus der Veröffentlichung mit dem Titel "A 45 ns 16 Mb DRAM with Triple-Well Structure" von Syuso Fujii et al. (Toshiba) in den Konferenzunterlagen zur IEEE International Solid State Circuit Conference am 17.02.1989 Session 16, FAM 16.6 bekannt. Dabei wird eine zweite Verdrahtungsebene nur zur Führung übergeordneter Bitschalterleitungen benutzt, die Fläche zwischen diesen Leitungen bleibt ungenutzt.

Der Erfindung liegt die Aufgabe zugrunde, eine DRAM-Zellenfeldarchitektur der eingangs genannten Art anzugeben, die bei minimalem Chipflächenbedarf einen hohen Parallelitätsgrad der Schreib/Lese-Operationen für Tests und eine relativ kurze Zugriffszeit beim normalen Einzelzugriff ermöglicht. Diese Aufgabe wird erfindungsgemäß durch die im kennzeichnenden Teil des Patentanspruches 1 angegebenen Merkmale gelöst.

Der mit der Erfindung erzielbare Vorteil liegt insbesondere darin, daß bei der nach der Erfindung ausgebildeten DRAM-Zellenfeldarchitektur gegenüber der zitierten Zellenfeldarchitektur von Toshiba, auf Grund der übergeordneten Bitleitungen, Bewerter eingespart werden können, sofern ein geringerer Parallelitätsgrad im Parallelbetrieb ausreichend ist.

Patentanspruch 2 bis 4 sind auf bevorzugte Ausbildungen der erfindungsgemäßen DRAM-Zellenfeldarchitektur gerichtet.

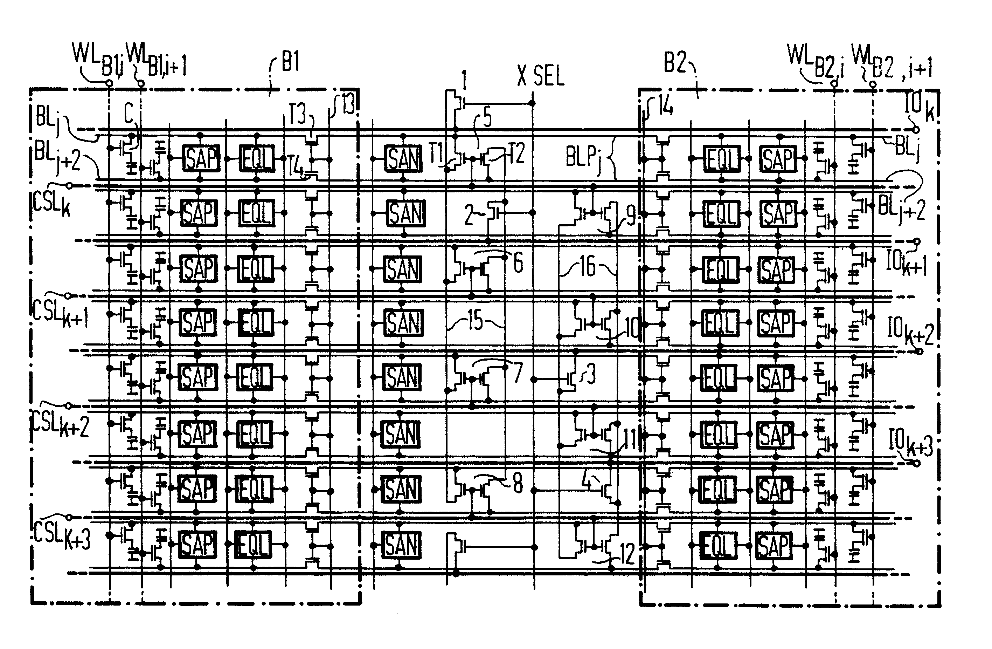

Die Erfindung wird nachfolgend anhand der Zeichnung näher erläutert. Dabei ist eine erfindungsgemäße Anordnung und Beschaltung der nach der Erfindung ausgebildeten Bit- und Bitschalterleitungen im Bereich zweier DRAM-Zellenfeldblöcken dargestellt.

In der Zeichnung werden, stellvertretend für alle Bitleitungspaare, acht Bitleitungspaare zweier Zellenfeldblöcke B1 und B2 betrachtet, wobei nur der rechte Teil des linken Zellenfeldblocks B1 und der linke Teil des rechten Zellenfeldblocks B2 jeweils zusammen mit der zugehörigen Beschaltung dargestellt sind. Für jedes Bitleitungspaar beider Zellenfeldblöcke besteht die Beschaltung, wie bei Bitleitungspaar ($BL_j$, $BL_{j+2}$), aus einem parallel zu den Bitleitungen geschalteten Bewerterteil SAP, einer parallel zu den Bitleitungen geschalteten Kurzschluß/Vorlade-Schaltung EQL und aus einem Paar von Schalttransistoren (T3, T4), durch die entweder das Bitleitungspaar ($BL_j$, $BL_{j+2}$) des linken Blocks B1 oder das Bitleitungspaar ($BL_j$, $BL_{j+2}$) des rechten Blocks B2 auf ein beiden Blöcken gemeinsames Leitungspaar $BLP_j$ schaltbar sind, wo sich dazu parallelgeschaltet der beiden Blöcken gemeinsame Bewerterteil SAN befindet. Aus beiden Blöcken wird jeweils immer nur jede zweite Bitleitung auf derselben Seite eines Blockes herausgeführt, was durch die Indizes j und j + 2 angedeutet ist. Die Basis der obengenannten Paare von Schalttransistoren ist jeweils im Fall des linken Blocks mit der Auswahlleitung 13 und im Fall des rechten Blocks mit der Auswahlleitung 14 verbunden. Das Zellenfeld selbst besteht aus elementaren DRAM-Zellen, die durch Bitleitungen wie $BL_j$ und $BL_{j+2}$, sowie durch Wortleitungen des linken Blocks $WL_{B1,i}$ bzw. $WL_{B1,i+1}$ und Wortleitungen des rechten Blocks $WL_{B2,i}$ bzw. $WL_{B2,i+1}$ adressierbar sind. In der Zeichnung sind die elementaren DRAM-Zellen nur an einigen Kreuzungspunkten zwischen Bit- und Wortleitungen beispielhaft dargestellt.

Zwischen den Bitleitungspaaren sind, in abwechselnder Reihenfolge, die übergeordneten Bitschaltteilleitungen $CSL_k$ bis $CSL_{k+3}$ und die erfindungsgemäßen, übergeordneten Bitleitungen $IO_k$ bis $IO_{k+3}$ gezeigt. Als übergeordnete Leitungen sind Leitungen zu verstehen, die blockübergreifend verfügbar sind. Bit- und Bitschalterleitungen sind vorzugsweise gemeinsam in der zweiten Verdrahtungsebene eingebaut, können sich aber auch in unterschiedlichen Verdrahtungsebenen befinden. Bei der erfindungsgemäßen Zellenfeldarchitektur befinden sich, für jeden Block getrennt, Paare von Leitungsabschnitten unterhalb der übergeordneten Leitungen, zum Beispiel in der Poly2 oder AluI-Ebene. Diese Paare von Leitungsabschnitten sind über die Bitschalter 5 bis 8 bzw. 9 bis 12 mit jeweils vier der insgesamt acht in der Zeichnung dargestellten und beiden Blöcken gemeinsamen Bitleitungspaaren verbunden. Die Bitschalter 5 bis 12 sind so angeordnet, daß jedes zweite beiden Blöcken gemeinsame Bitleitungspaar, wie zum Beispiel $BLP_j$, mit dem jeweils einem Block zugeordneten Paar von Leitungen 15 bzw. 16 verbindbar ist. Ein Bitleitungspaar kann also entweder über das dem linken Block B1 zugeordnete Paar von Leitungen oder über das dem rechten Block B2 zugeordnete Paar von Leitungen weitergeschaltet werden. Die Bitschalter sind derart aufgebaut, daß wie im Fall von Schalter 5, die Transistoren T1 und T2 das Bitleitungspaar $BL_j$ bzw. $BL_{j+2}$ auf das Paar von Leitungsabschnitten 15 durchschalten, wenn die Schalttransistoren T1 bzw. T2 ein entsprechendes Ansteuersignal durch die übergeordnete Bitschalterleitung $CSL_k$ erhalten. Das Paar von Leitungsabschnitten 15 ist durch die beiden Schalttransistoren 1 und 2 mit den übergeordneten Bitleitungen $IO_k$ bzw. $IO_{k+1}$ verbindbar, gleiches gilt für das Paar von Leitungsabschnitten 16, welches durch die Schalttransistoren 3 und 4 mit den übergeordneten Bitleitungen $IO_{k+2}$ bzw. $IO_{k+3}$ verbindbar ist. Alle Schalttransistoren die Paare von Leitungsabschnitten mit übergeordneten Bitleitungspaaren verbinden sind mit ihrer Basis jeweils mit dem Blockauswahlsignal XSEL verbunden. Die in der Zeichnung dargestellten Paare von Leitungsabschnitten 15 bzw. 16 sind mit jeweils vier Bitschaltern 5 bis 8 bzw. 9 bis 12 verbunden und stellen damit die Schaltung mit dem größten Parallelitätsgrad hinsichtlich der Schreib/Leseoperationen dar. Längere Paare von Leitungsabschnitten, die zum Beispiel jeweils mit acht Bitschaltern verbunden sind, können nach demselben Prinzip aufgebaut werden, wenn dies aufgrund weiterer Bedingungen erforderlich sein sollte.

Erhält die in der Zeichnung dargestellte Auswahlleitung 13 ein Signal, so werden die Bitleitungen $BL_j$ bzw. $BL_{j+2}$ des linken Blocks B1 auf das beiden Blöcken gemeinsame Bitleitungspaar $BLP_j$ geschaltet. Das Signal auf der Auswahlleitung 14 jedoch muß die Schalttransistoren sperren, so daß der rechte Block B2 von den beiden Blöcken gemeinsamen Bitleitungspaaren $BLP_j$ abgekoppelt ist. Es können nun beispielsweise die Bitleitungen $BL_j$ und $BL_{j+2}$ des linken Blocks B1 durch die Schaltung EQL miteinander kurzgeschlossen und auf eine beiden Bitleitungen gemeinsame Spannung vorgeladen werden. Ist beispielsweise eine elementare DRAM-Zelle durch die Bitleitung $BL_j$ und durch die Wortleitung $WL_{B1,i}$ ausgewählt, so kann ein Teil der elektrischen Ladung des Zellenkondensators C auf die Bitleitung $BL_j$ gelangen und das so entstandene Zellensignal auf der ausgewählten Bitleitung $BL_j$ gegenüber dem Potential auf einer zweiten, als Referenzleitung dienenden Bitleitung $BL_{j+2}$ durch den aus den beiden Bewerterteilen SAP und SAN gebildeten Bewerter detektiert und verstärkt werden. Je nach Inhalt der ausgewählten Speicherzelle wird nun eine davon abhängige Spannung zwischen den Leitungen des beiden Blöcken gemeinsamen Bitleitungspaares $BLP_j$ anliegen.

Erfindungsgemäß kann, wie in der Zeichnung gezeigt, ein Bitleitungspaar $BLP_j$ mit Hilfe des Bitschalters 5 auf das Paar von Leitungsabschnitten 15 durch die Schalttransistoren T1 und T2 geschaltet werden, sofern ein geeignetes Signal an der übergeordneten Bitschalterleitung $CSL_k$ anliegt. Sollen in gleicher Weise andere Bitleitungspaare des linken Blocks B1 auf das Paar von Leitungsabschnitten 15 mit Hilfe der Bitschalter 6 bis 8 geschaltet werden, so können diese Bitschalter, wie für Bitschalter 5 bereits erläutert, durch die übergeordneten Bitschalterleitungen $CSL_{k+1}$ bis $CSL_{k+3}$ angesteuert werden. Dabei ist Sorge zu tragen, daß immer nur ein Bitschalter ein Bitleitungspaar mit einem Paar von Leitungsabschnitten verbindet, dies kann beispielsweise durch einen übergeordneten 1 aus 4-Dekoder zur Ansteuerung der übergeordneten Bitschalterleitungen gelöst werden. Durch ein Blockauswahlsignal XSEL kann jetzt erfindungsgemäß, wie in der Zeichnung dargestellt, die am Paar von Leitungsabschnitten 15 vorhandene Information über die Schalttransistoren 1 und 2 an die übergeordneten Bitleitungen $IO_k$ und $IO_{k+1}$ weiter verbunden werden. Eine eindeutige Blockauswahl ist nur durch die Schalterleitungen 13 und 14 möglich, da aufgrund der geteilten Bewerter SAP/SAN durch das Blockauswahlsignal XSEL immer zwei benachbarte Blöcke gleichzeitig angesprochen werden. Die am linken Zellenfeldblock B1 erläuterten Zusammenhänge gelten in analoger Weise auch für den rechten Zellenfeldblock B2.

## Patentansprüche

1. Eine DRAM-Zellenfeldarchitektur mit mehreren Zellenfeldblöcken (B1, B2), die aus einer Vielzahl von durch Wort- und Bitleitungen adressierbaren DRAN-Zellen und Bitschaltern (5 bis 12) zur Auswahl von Bitleitungspaaren aus einer Mehrzahl von Bitleitungspaaren ($BLP_j$) besteht, wobei die Ansteuerung der Bitschalter (5 bis 12) durch übergeordnete Bitschalterleitungen ($CSL_k...CSL_{k+3}$) erfolgt, **dadurch gekennzeichnet,** daß sich zusätzlich zu den übergeordneten Bitschalterleitungen ($CSL_k...CSL_{k+3}$) noch übergeordnete Bitleitungen ($IO_k...IO_{k+3}$) in der selben oder einer weiteren Verdrahtungsebene befinden, wobei die übergeordneten Bitleitungen jeweils mit den durch die Bitschalter (5 bis 12) bereits vorausgewählten und mit Paaren von Leitungsabschnitten (15, 16) verbundenen Bitleitungspaaren des mit Hilfe von Blockauswahlsignalen (13, 14 und XSEL) ausgewählten Zellenfeldblockes durch Schalttransistoren (1 bis 4) verbindbar sind.

2. DRAM-Zellenfeldarchitektur nach Anspruch 1, **dadurch gekennzeichnet,** daß jedem Zellenfeldblock eigene Paare von Leitungsabschnitten (15, 16) zugeordnet sind und daß bei benachbarten Zellenfeldblöcken Verbindungen zwischen den übergeordneten Bitleitungen und den Zellen eines Zellenfeldblocks entweder über die dem Zellenfeldblock zugeordneten Paare von Leitungsabschnitten (15) oder über die Paare von Leitungsabschnitten des benachbarten Zellenfeldblockes (16) herstellbar sind.

3. DRAN-Zellenfeldarchitektur nach Anspruch 1, **dadurch gekennzeichnet,** daß die übergeordneten Bitschalterleitungen ($CSL_k...CSL_{k+3}$) und die übergeordneten Bitleitungen ($IO_k...IO_{k+3}$) parallel zu den Bitleitungspaaren ($BLP_j$) angeordnet sind und sich diese in räumlicher Folge abwechseln und daß zur Vorauswahl von Bitleitungspaaren dienenden Paare von Leitungsabschnitten (15, 16) und die Leitungen für die Blockauswahlsignale (XSEL) parallel zu den Wortleitungen ($WL_{B1,i}$, $WL_{B1,i+1}$, $WL_{B2,i}$, $WL_{B2,i+1}$) verlaufen.

4. DRAM-Zellenfeldarchitektur nach Anspruch 1, **dadurch gekennzeichnet,** daß jeweils vier der acht Bitleitungspaare ($BLP_j$) über Bitschalter (5 bis 8, 9 bis 12) mit einem Paar von Leitungsabschnitten (15, 16) verbindbar sind.